# EUROPEAN PATENT APPLICATION

(11) **EP 4 682 857 A1**
(43) Date of publication of application: **21.01.2026**
(21) Application number: 24856590.5
(22) Date of filing: 17.05.2024
(51) Int. Cl.: G09F 9/302, H01L 25/075, H10H 29/01, G09F 9/33

(54) **DISPLAY APPARATUS**

(30) Priority: 21.08.2023 KR 20230109263
(71) Applicant: Samsung Electronics Co., Ltd., Suwon-si, Gyeonggi-do 16677 (KR)
(72) Inventor: PARK, Jeonghoon, Suwon-si Gyeonggi-do 16677 (KR); LEE, Wookjin, Suwon-si Gyeonggi-do 16677 (KR); KIM, Minchan, Suwon-si Gyeonggi-do 16677 (KR); LEE, Bongju, Suwon-si Gyeonggi-do 16677 (KR)
(74) Representative: Appleyard Lees IP LLP
(86) International application number: PCT/KR2024/006719
(87) International publication number: WO 2025/041970

(57) **Abstract**

A display apparatus includes a display module provided with a magnetic material; a frame configured to support the display module; and a connection device. The connection device includes: a fixing part fixed to the frame; an adjustment part movably coupled to the fixing part so as to be movable with respect to the fixing part; and an adjustment magnet movably coupled to the adjustment part so as to movable with respect to the adjustment part, and configured to generate an attractive force between the magnetic material and the adjustment magnet to mount the display module too the frame so that the display module is supported by the frame with a gap between the display module and the frame. The gap is adjustable by movement of the adjustment part with respect to the fixing part.

## Description

### [Technical Field]

The present disclosure relates to a display apparatus that displays images by combining modules in which emissive light-emitting devices are mounted on a substrate.

### [Background Art]

A display apparatus is a type of an output device that visually displays data information, such as characters and figures, images, and the like.

In general, for a display apparatus, a liquid crystal panel requiring a backlight, or an organic light-emitting diode (OLED) panel formed of an organic compound film that emits light by itself in response to an electric current have been mainly used. However, the liquid crystal panel has a slow response time and large power consumption, and requires a backlight due to limitation on emitting light by itself, having a difficulty in providing the display apparatus in a compact size. In contrast, the OLED panel does not require a backlight due to emitting light by itself, and thus achieves slim thickness, but the OLED panel is susceptible to a burn-in phenomenon in which when the same screen is displayed for a long time, a part of the screen remains even when the screen is switched due to the life of sub-pixels being ended.

Accordingly, in order to find a replacement for the LCD panel and the OED panel, research has been conducted on a micro light emitting diode (micro LED or µLED) panel that mounts an inorganic light emitting diode on a substrate and uses the inorganic light emitting diode itself as a pixel.

Micro light-emitting diode display panel (hereinafter, referred to as a micro LED panel) is one of flat panel display panels and includes a plurality of inorganic light-emitting diodes (inorganic LEDs) each having a size of 100 micrometers or less.

Such an LED panel is a self-emissive device but is not susceptible to OLED burn-in as an inorganic light-emitting device, and has excellent brightness, resolution, power consumption, and durability.

Compared to the LCD panels that require backlighting, micro LED display panels provide better contrast, response time, and energy efficiency. OLEDs and micro-LEDs (i.e., inorganic LEDs) are both energy efficient, but micro LEDs have excellent brightness, luminous efficiency, and lifespan compared to OLEDs.

In addition, the micro LEDs may achieve a substrate-level display modulation by arranging LEDs on a circuit board in units of pixels, and provide various resolutions and screen sizes of display according to the customer's order.

### [Disclosure]

### [Technical Problem]

One aspect of the disclosure provides a display apparatus with an improved manufacturing process.

Another aspect of the disclosure provides a display apparatus with ease of maintenance and/or repair.

Another aspect of the disclosure provides a display apparatus with lower risk of damage to a display module during maintenance and/or repair.

The technical objectives of the present disclosure are not limited to the above, and other objectives that are not described above may become apparent to those of ordinary skill in the art based on the following description.

### [Technical Solution]

According to an aspect of the disclosure, a display apparatus includes a display module provided with a magnetic material; a frame configured to support the display module; and a connection device. The connection device includes: a fixing part fixed to the frame; an adjustment part movably coupled to the fixed part so as to be movable with respect to the fixing part; and an adjustment magnet movably coupled to the adjustment part so as to movable with respect to the adjustment part, and configured to generate an attractive force between the magnetic body and the adjustment magnet to mount the display module to the frame so that the display module is supported by the frame with a gap between the display module and the frame. The gap is adjustable by movement of the adjustment part with respect to the fixing part.

According to an aspect of the disclosure, a display apparatus includes a display module on which a magnetic material is provided; a frame configured to support the display module; and a connection device configured to mount the display module on the frame. The connection device includes a fixing part fixed to the frame, an adjustment part movably coupled to the fixing part, and an adjustment magnet movably coupled to the adjustment part, the adjustment magnet being movable between a first position at which the display module is fixable to the frame and a second position at which the display module is released from the frame. The display module is adjustable in distance to the frame based on the adjustment part moving relative to the fixed part in a state in which the display module is mounted on the frame by attraction between the adjustment magnet and the magnetic material.

### [Description of Drawings]

FIG. 1 is a view illustrating a display apparatus according to an embodiment of the present disclosure.
FIG. 2 is an exploded view illustrating main components of the display apparatus according to an embodiment of the present disclosure.
FIG. 3 is an enlarged cross-section of some components of a display module of the display apparatus according to an embodiment of the present disclosure.
FIG. 4 is a view illustrating a mounting structure of a display module and a frame of the display apparatus according to an embodiment of the present disclosure.
FIG. 5 is a view illustrating a portion of the frame of the display apparatus according to an embodiment of the present disclosure.
FIG. 6 is an exploded view illustrating a connection device according to an embodiment of the present disclosure.
FIG. 7 is an exploded view illustrating the connection device according to an embodiment of the present disclosure, viewed in an orientation different from that of FIG. 6.
FIG. 8 is a front view illustrating a portion of the frame on which the connection device is mounted according to an embodiment of the present disclosure.
FIG. 9 is a rear view illustrating a portion of the frame on which the connection device according to an embodiment of the present disclosure is mounted.
FIG. 10 is a cross sectional view taken along line A-A' of FIG. 8 showing a portion of the frame on which the connecting device according to an embodiment of the present disclosure.
FIG. 11 is a cross-sectional view of the display module mounted on the frame according to an embodiment of the present disclosure.
FIG. 12 is a rear view illustrating a rotation of an adjustment part in the first direction according to an embodiment of the present disclosure.
FIG. 13 is a view illustrating the display module moved away from the frame as the adjustment part rotates in the first direction according to an embodiment of the present disclosure.
FIG. 14 is a rear view illustrating a rotation of the adjustment part in the second direction according to an embodiment of the present disclosure.
FIG. 15 is a view illustrating the display module moved closer to a frame as the adjustment part rotates in the second direction according to an embodiment of the present disclosure.
FIG. 16 is a front view illustrating a rotation of the adjustment part in the first direction while the display module is separated from the frame according to an embodiment of the present disclosure.
FIG. 17 is a view illustrating the adjustment part moved forward as the adjustment part rotates in the first direction while the display module is separated from the frame according to an embodiment of the present disclosure.
FIG. 18 is a view illustrating a rotation of the adjustment part in the second direction while the display module is separated from the frame according to an embodiment of the present disclosure.
FIG. 19 is a view illustrating the adjustment part moved rearward as the adjustment part rotates in the second direction while the display module is separated from the frame according to an embodiment of the present disclosure.
FIG. 20 is a view illustrating a portion of the display apparatus according to an embodiment of the present disclosure and a jig device for separating the display module from the frame.
FIG. 21 is a view illustrating a state in which the jig device is attached to the display apparatus to separate the display module of the display apparatus from the frame according to an embodiment of the present disclosure.
FIG. 22 is a view illustrating a state in which the display module of the display apparatus according to an embodiment of the present disclosure is separated from the frame by the jig device.
FIG. 23 is a view illustrating a state in which the jig apparatus is attached to the display apparatus to mount the display module of the display apparatus to the frame according to an embodiment of the present disclosure.
FIG. 24 is a view illustrating a state in which the display module of the display apparatus according to an embodiment of the present disclosure is mounted on the frame using the jig device.

### [Modes of the Disclosure]

The various embodiments of the disclosure and terminology used herein are not intended to limit the technical features of the disclosure to the specific embodiments, but rather should be understood to cover all modifications, equivalents, and alternatives falling within the concept and scope of the disclosure.

In the description of the drawings, like numbers refer to like elements throughout the description of the drawings.

The singular forms preceded by "a," "an," and "the" corresponding to an item are intended to include the plural forms as well unless the context clearly indicates otherwise.

In the disclosure, a phrase such as "A or B," "at least one of A and B," "at least one of A or B," "A, B or C," "at least one of A, B and C," and "at least one of A, B, or C" may include any one of the items listed together in the corresponding phrase of the phrases, or any possible combination thereof.

The term "and/or" includes combinations of one or all of a plurality of associated listed items.

As used herein, such terms as "1st" and "2nd," or "first" and "second" may be used to simply distinguish a corresponding component from another, and does not limit the components in other aspect (for example., importance or order).

When one (e.g., a first) element is referred to as being "coupled" or "connected" to another (e.g., a second) element with or without the term "functionally" or "communicatively," it means that the one element is connected to the other element directly, wirelessly, or via a third element.

It will be understood that the terms "include", "comprise" and/or "have" when used in this specification, specify the presence of stated features, integers, steps, operations, elements, and/or components, but do not preclude the presence or addition of one or more other features, integers, steps, operations, elements, components, and/or groups thereof.

It is to be understood that if a certain component is referred to as being "coupled with," "coupled to," "supported on" or "in contact with" another component, it means that the component may be coupled with the other component directly or indirectly via a third component.

Throughout the specification, when a member is referred to as being "on" another member, the member is in contact with another member or yet another member is interposed between the two members.

Hereinafter, embodiments according to the present disclosure will be described in detail with reference to the accompanying drawings.

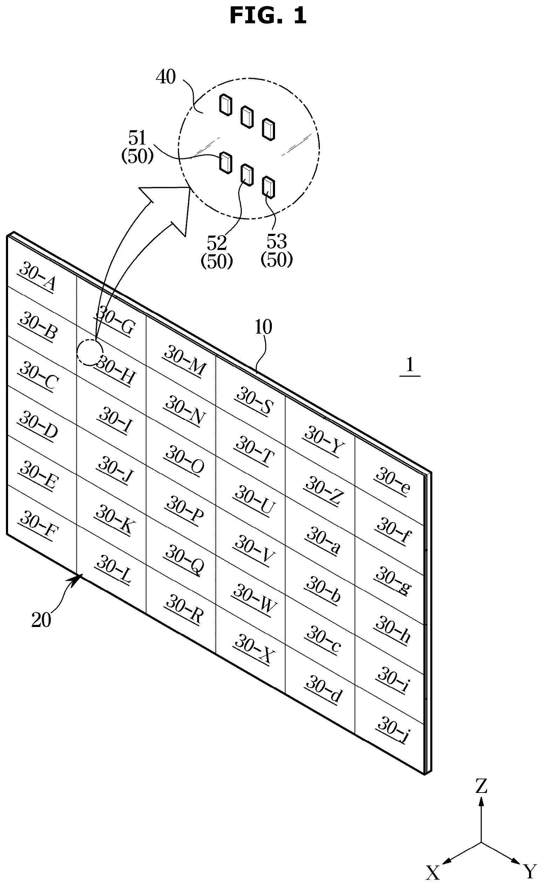

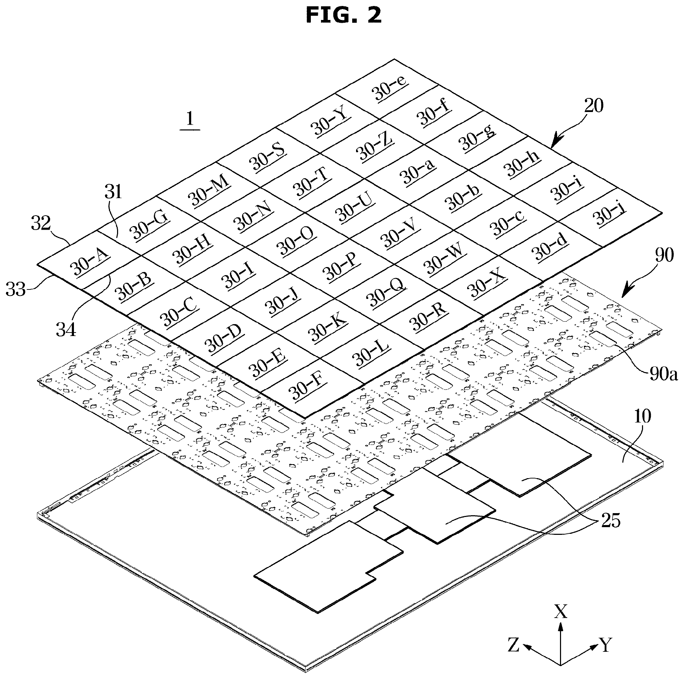

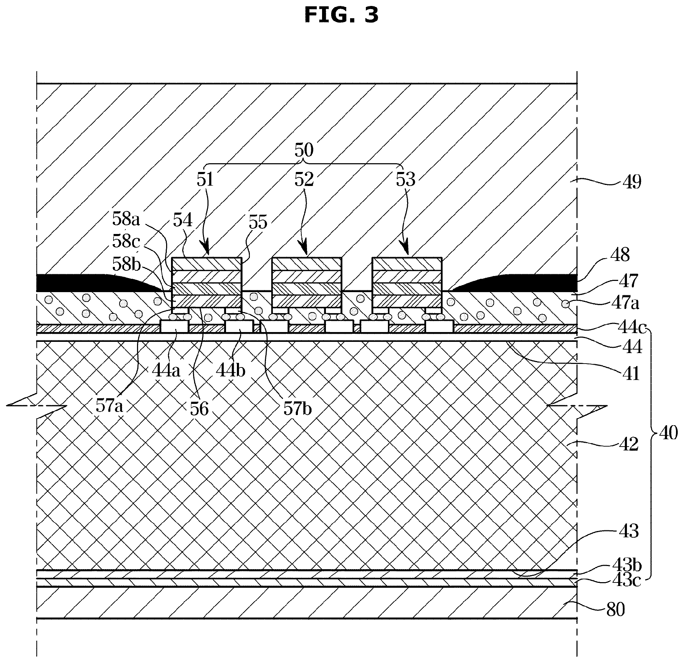

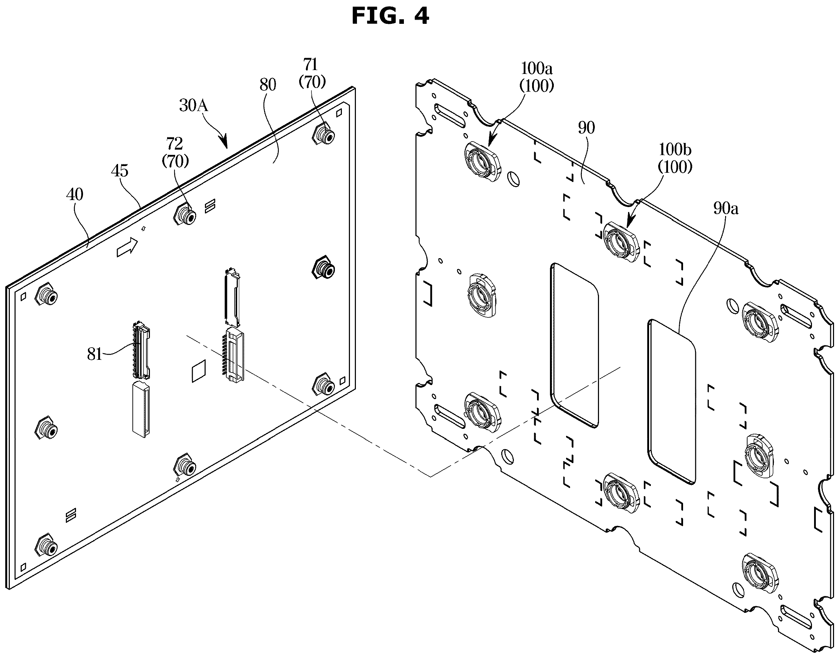

FIG. 1 is a view illustrating a display apparatus according to an embodiment of the present disclosure. FIG. 2 is an exploded view illustrating main components of the display apparatus according to an embodiment of the present disclosure. FIG. 3 is an enlarged cross-section of some components of a display module of the display apparatus according to an embodiment of the present disclosure. FIG. 4 is a view illustrating a mounting structure of a display module and a frame of the display apparatus according to an embodiment of the present disclosure.

In the following description, components of a display apparatus 1 including a plurality of inorganic light emitting diodes 50 shown in the drawings are components in micro-units having a size of several µm to several hundreds of µm, and the sizes of some components (a plurality of inorganic light emitting diodes 50, a black matrix 48, etc.) shown in the drawings may be exaggerated for the sake of convenience of description.

The display apparatus 1 is an apparatus that displays information, material, data, etc. as characters, figures, graphs, images, etc., and may be implemented as a television (TV), a personal computer (PC), a mobile, a digital signage, etc.

According to the embodiment of the disclosure, referring to FIGS. 1 and 2, the display apparatus 1 includes a display panel 20 displaying an image, a board 25 for driving and/or controlling the display panel 20, a frame 90 supporting the display panel 20, and a rear cover 10 covering a rear surface of the frame 90.

The display panel 20 may include a plurality of display modules 30A to 30j, a driving board for driving each of the display modules 30A to 30j, and a Timing Controller (TCON) board generating a timing signal required for controlling each of the display modules 30A to 30j.

The board 25 may include a circuit board for driving and/or controlling the display apparatus 1. As an example, the board 25 may include at least one of a power board for supplying power to the display panel 20, a control board for controlling the overall operation of the display panel 20, and a communication board for communication with external devices.

The rear cover 10 may support the display panel 20. The rear cover 10 may be installed on the floor through a stand, or may be installed on a wall through a hanger.

The plurality of display modules 30A to 30j may be arranged in upper and lower side directions and left and right side directions so as to be adjacent to each other. The plurality of display modules 30A to 30j may be arranged in an M × N matrix form, wherein M and N are natural numbers. In the embodiment, the display modules 30A to 30j are provided as thirty six display modules 30A to 30j and are arranged in a 6 × 6 matrix form, but there is no limitation on the number and arrangement method of the plurality of display modules 30A to 30j.

The plurality of display modules 30A to 30j may be installed on the frame 90. The frame 90 may support the plurality of display modules 30A to 30j. The plurality of display modules 30A to 30j may be installed on the frame 90 through various methods, such as magnetic force using a magnet, a mechanical fitting structure, or a bonding. The rear cover 10 is coupled to the rear of the frame 90, and the rear cover 10 may form the rear appearance of the display apparatus 1. The frame 90 may include a plurality of module openings 90a formed to correspond to the plurality of display modules 30A to 30j.

The rear cover 10 may include a metal material. Accordingly, heat generated from the plurality of display modules 30A to 30j and the frame 90 may be easily conducted to the rear cover 10, thereby increasing the heat dissipation efficiency of the display apparatus 1.

The display apparatus 1 according to various embodiments of the disclosure may implement a large screen by tiling the plurality of display modules 30A to 30j.

According to another embodiment, in the plurality of display modules 30A to 30j, each single display module may be applied to a display apparatus. That is, the display modules 30A to 30j may be individually installed on an electronic product or a machine part, such as a wearable device, a portable device, a handheld device, and other various displays that require various displays, or may be assembled in a matrix form as in the embodiment and used for a display apparatus, such as a monitor for a PC, a high-definition TV and signage, and an electronic display.

The plurality of display modules 30A to 30j may have the same configuration. Therefore, the description of any one display module described below may be equally applied to all other display modules.

One of the plurality of display modules 30A to 30j, for example, the first display module 30A may be formed in a quadrangle type. Alternatively, the first display module 30A may be provided in a rectangular type or a square type.

Accordingly, the first display module 30A may include edges 31, 32, 33, and 34 formed in the upper and lower side direction and the left and right side directions with respect to a first direction X, which is the forward direction.

Hereinafter, for convenience of description, the first display module 30A will be referred to as the display module 30A, and only the first display module 30A will be described.

Referring to FIG. 3, the display module 30A may include a substrate 40 and a plurality of inorganic light emitting diodes 50 mounted on the substrate 40. The plurality of inorganic light emitting diodes 50 may be mounted on a mounting surface 41 of the substrate 40 facing in the first direction X. In FIG. 3, the thickness of the substrate 40 in the first direction X is shown to be exaggeratedly thick for convenience of description.

The substrate 40 may be formed in a quadrangle type. As described above, the display module 30A may be formed in a quadrangle shape, and the substrate 40 may be formed in a quadrangle shape to correspond to the display module 30A.

The substrate 40 may be provided in a rectangular shape or a square shape.

Therefore, the substrate 40 may include four edges E corresponding to the edges 31, 32, 33, and 34 of the display module 30A formed in the upper and lower side directions and in the left and right side directions with respect to the first direction X, which is the forward direction.

The substrate 40 may include a base substrate 42, a mounting surface 41 forming one surface of the base substrate 42, a rear surface 43 forming the other surface of the base substrate 42 and arranged on a side opposite of the mounting surface 41, and a side surface 45 arranged between the mounting surface 41 and the rear surface 43.

The substrate 40 may include a thin film transistor (TFT) layer 44 formed on the base substrate 42 to drive the inorganic light emitting diodes 50. The base substrate 42 may include a glass substrate. That is, the substrate 40 may include a chip on glass (COG) type substrate. The substrate 40 may include first and second pad electrodes 44a and 44b provided to electrically connect the inorganic light emitting diodes 50 to the TFT layer 44.

A TFT constituting the TFT layer 44 is not limited to a specific structure or type, and may be configured in various embodiments. That is, the TFT of the TFT layer 44 according to an embodiment of the disclosure may be implemented as a Low Temperature Poly Silicon (LTPS) TFT, an oxide TFT, a Si (poly silicon, or a-silicon) TFT, an organic TFT, a graphene TFT, or the like.

In addition, when the base substrate 42 of the substrate 40 is formed of a silicon wafer, the TFT layer 44 may be replaced by a Complementary Metal-Oxide Semiconductor (CMOS) type transistor or an n-type or p-type MOSFET transistor.

The plurality of inorganic light emitting diodes 50 may include inorganic light emitting diodes formed of an inorganic material and having a width, a length, and a height, each of several µm to several tens of µm. The micro-inorganic light emitting diode may have a short side of 100 µm or less among the width, the length, and the height. That is, the inorganic light emitting diode 50 may be picked up from a sapphire or silicon wafer and transferred directly onto the substrate 40. The plurality of inorganic light emitting diodes 50 may be picked up and transported through an electrostatic method using an electrostatic head or a stamp method using an elastic polymer material, such as polydimethylsiloxane (PDMS) or silicon, as a head.

The plurality of inorganic light emitting diodes 50 is a light emitting structure including an n-type semiconductor 58a, an active layer 58c, a p-type semiconductor 58b, a first contact electrode 57a, and a second contact electrode 57b.

One of the first contact electrode 57a and the second contact electrode 57b is electrically connected to the n-type semiconductor 58a, and the other is provided to be electrically connected to the p-type semiconductor 58b.

The first contact electrode 57a and the second contact electrode 57b may be in the form of a flip chip so as to be disposed parallel with each other while facing in the same direction (a direction opposite to the light emission direction).

The inorganic light emitting diode 50 includes a light emitting surface 54 disposed to face in the first direction X when mounted on the mounting surface 41, a side surface 55, and a bottom surface 56 disposed at a side opposite to the light emitting surface 54, and the first contact electrode 57a and the second contact electrode 57b may be formed on the bottom surface 56.

That is, the contact electrodes 57a and 57b of the inorganic light emitting diode 50 may be disposed on a side opposite to the light emitting surface 54 so as to be disposed at a side opposite and facing away the light emission direction.

The contact electrodes 57a and 57b may be disposed to face the mounting surface 41, may be electrically connected to the TFT layer 43, and the light emitting surface 54 may be arranged to emit light in a direction opposite and facing away from a direction in which the contact electrodes 57a and 57b are oriented.

Therefore, when light generated from the active layer 58c is emitted in the first direction X through the light emitting surface 54, the light may be emitted in the first direction X without interfering with the first contact electrode 57a or the second contact electrode 57b.

That is, the first direction X may be defined as a direction in which light is emitted from the light emitting surface 54.

The first contact electrode 57a and the second contact electrode 57b may be electrically connected to the first pad electrode 44a and the second pad electrode 44b formed at a side of the mounting surface 41 of the substrate 40, respectively.

The inorganic light emitting diode 50 may be directly connected to the pad electrodes 44a and 44b through a bonding configuration, such as an anisotropic conductive layer 47 or solder.

The anisotropic conductive layer 47 may be formed on the substrate 40 to mediate electrical bonding between the contact electrodes 57a and 57b and the pad electrodes 44a and 44b. The anisotropic conductive layer 47 may represent an anisotropic conductive adhesive attached on a protective film, and have a structure in which conductive balls 47a are scattered in an adhesive resin. The conductive balls 47a may be conductive spheres surrounded by a thin insulating film, and when the insulating film is broken by a pressure, electrical connection occurs between conductors.

The anisotropic conductive layer 47 may include an anisotropic conductive film (ACF) in the form of a film and an anisotropic conductive paste (ACP) in the form of a paste.

Therefore, when the plurality of inorganic light emitting diodes 50 are mounted on the substrate 40, a pressure applied to the anisotropic conductive layer 47 causes the insulating film of the conductive balls 47a to be broken, such that the contact electrode 57a and 57b of the inorganic light emitting diode 50 may be electrically connected to the pad electrodes 44a and 44b of the substrate 40.

However, although not shown in the drawings, the plurality of inorganic light emitting diodes 50 may be mounted on the substrate 40 through a solder instead of the anisotropic conductive layer 47. The inorganic light emitting diode 50 may be aligned on the substrate 40 first, and then the inorganic light emitting diode 50 may be subject to a reflow process to be bonded to the substrate 40.

The plurality of inorganic light emitting diodes 50 may include a red light emitting device 51, a green light emitting device 52, and a blue light emitting device 53, and the light emitting devices 50 may be mounted on the mounting surface 41 of the substrate 40 in a series of the red light emitting device 51, the green light emitting device 52, and the blue light emitting device 53 as one unit. A series of the red light emitting device 51, the green light emitting device 52, and the blue light emitting device 53 may form one pixel. In this case, the red light emitting device 51, the green light emitting device 52, and the blue light emitting device 53 may each form a subpixel.

The red light emitting device 51, the green light emitting device 52, and the blue light emitting device 53 may be arranged in a line at predetermined intervals as in the embodiment of the disclosure, or may be arranged in a different shape, such as a triangular shape.

The substrate 40 may include a light absorbing layer 44c to improve the contrast by absorbing external light. The light absorbing layer 44c may be formed at a side of the mounting surface 41 of the substrate 40 as a whole. The light absorbing layer 44c may be formed between the TFT layer 44 and the anisotropic conductive layer 47.

The display module 30A may further include a black matrix 48 formed between the plurality of inorganic light emitting diodes 50.

The black matrix 48 may perform a function of supplementing the light absorbing layer 44c entirely formed at a side of the mounting surface 41 of the substrate 40. That is, the black matrix 48 absorbs external light and allows the substrate 40 to appear black, thereby improving the contrast of the screen.

The black matrix 48 may have a black color.

In the embodiment, the black matrix 48 is formed to be disposed between pixels each formed by a series of the red light emitting device 51, the green light emitting device 52, and the blue light emitting device 53. In another embodiment, the black matrix 48 may be formed at a higher precision and partition each of the light emitting devices 51, 52, and 53, which are sub-pixels.

The black matrix 48 may be formed in a grid shape having a horizontal pattern and a vertical pattern so as to be disposed between pixels.

The black matrix 48 may be formed by applying a light-absorbing ink on the anisotropic conductive layer 47 through an ink-jet process and curing the light-absorbing ink, or by coating a light-absorbing film on the anisotropic conductive layer 47.

That is, on the anisotropic conductive layer 47 formed entirely on the mounting surface 41, the black matrices 48 may be formed gaps between the plurality of inorganic light emitting diodes 50 in which the plurality of inorganic light emitting diodes 50 are not mounted.

The plurality of display module 30Amay include a front cover 49 arranged on the mounting surface 41 in the first direction X to cover the mounting surface 41 of the display module 30A.

The front cover 49 may be provided in plurality so as to be respectively formed on the display module 30A in the first direction X.

The front cover 49 may include a film (not shown).

The film (not shown) of the front cover 49 may be formed of a functional film with optical performance.

The front cover 49 may be provided to cover the substrate 40 to protect the substrate 40 from external force.

According to embodiments of the disclosure, an adhesive layer (not shown) of the front cover 49 may be provided to have a predetermined height or more in the first direction X to which the mounting surface 41 or the light emitting surface 54 faces. This is to sufficiently fill a gap that may be formed between the front cover 49 and the plurality of inorganic light emitting devices 50 when the front cover 49 is formed on the substrate 40.

The plurality of inorganic light emitting devices 50 may be electrically connected to a pixel driving wiring (not shown) formed on the mounting surface 41, and an upper wiring layer (not shown) extending through the side surface 45 of the substrate 40 and formed as a pixel driving wiring (not shown).

The upper wiring layer may be electrically connected to a side wiring (not shown) formed on the side surface 45 of the substrate 40. The side wiring (not shown) may be provided in a thin film form.

The upper wiring layer may be connected to the side wiring by an upper connection pad (not shown) formed on the edge E side of the substrate 40.

The side wiring may extend along the side surface 45 of the substrate 40 and may be connected to a rear wiring layer 43b formed on the rear surface 43.

An insulating layer 43c covering the rear wiring layer 43b may be formed on the rear wiring layer 43b in a direction to which the rear surface of the substrate 40 faces.

That is, the plurality of inorganic light emitting devices 50 may be sequentially and electrically connected to the upper wiring layer, the side wiring, and the rear wiring layer 43b.

Further, as illustrated in FIGS. 3 and 4, the display module 30A may include a driver circuit board 80 provided to electrically control the plurality of inorganic light emitting devices 50 mounted on the mounting surface 41. The driver circuit board 80 may be formed of a printed circuit board. The driver circuit board 80 may be arranged on the rear surface 43 of the substrate 40 in the first direction X. The driver circuit board 80 may include a plurality of chips. The driver circuit board 80 may be electrically connected to the rear wiring layer 43b so as to be electrically connected to the plurality of inorganic light emitting diodes 50.

As the driver circuit board 80 is electrically connected to the substrate 40, the driver circuit board 80 may transmit power and electrical signals to the plurality of inorganic light emitting devices 50.

The driver circuit board 80 may transmit data signals to the substrate 40. The driving circuit board 80 may transmit power to the substrate 40.

As an example, the driver circuit board 80 may be electrically connected to the board 25 (see FIG. 2). The board 25 may be disposed on a rear side of the frame 90, and the board 25 may be connected to the driver circuit board 80 through a cable at the rear side of the frame 90. The cable for connecting the board 25 and the driver circuit board 80 may pass through a module opening 90a of the frame 90. The driver circuit board 80 may include a driver connector 81 to which the cable for connection to the board 25 is connected.

The display apparatus 1 may include a magnetic material 70 provided on the display module 30A. The magnetic material 70 may be located on the rear surface of the display module 30A. The magnetic material 70 may be provided on a surface facing the frame 90 when the display module 30A is mounted to the frame 90. For example, the magnetic material 70 may be attached to the display module 30A with an adhesive or the like.

The magnetic material 70 may be provided as a plurality of magnetic materials 70 along the edge of the display module 30A. The magnetic material 70 may include a first magnetic material 71 located on the edge of the display module 30A and a second magnetic material 72 located on the edge of the display module 30A and spaced apart from the first magnetic material 71. The first magnetic material 71 and the second magnetic material 72 may have the same configuration. In FIG. 4, the display apparatus 1 according to an embodiment is shown as being provided with eight magnetic materials 70, but the number of magnetic materials 70 is not limited thereto.

The display apparatus 1 may include a connection device 100 for mounting the display module 30A on the frame 90. The connection device 100 may interact with the magnetic material 70. Based on the interaction between the connection device 100 and the magnetic material 70, the display module 30A may be mounted to the frame 90 or separated from the frame 90.

The connection device 100 may be positioned to correspond to the magnetic material 70. The connection device 100 may include a first connection device 100a located to correspond to the first magnetic material 71 and a second connection device 100b located to correspond to the second magnetic material 72 and spaced apart from the first connection device 100a. The first connection device 100a and the second connection device 100b may have the same configuration. In FIG. 4, the display apparatus 1 according to an embodiment is shown as being provided with eight connection devices 100, but the number of connection devices 100 is not limited thereto.

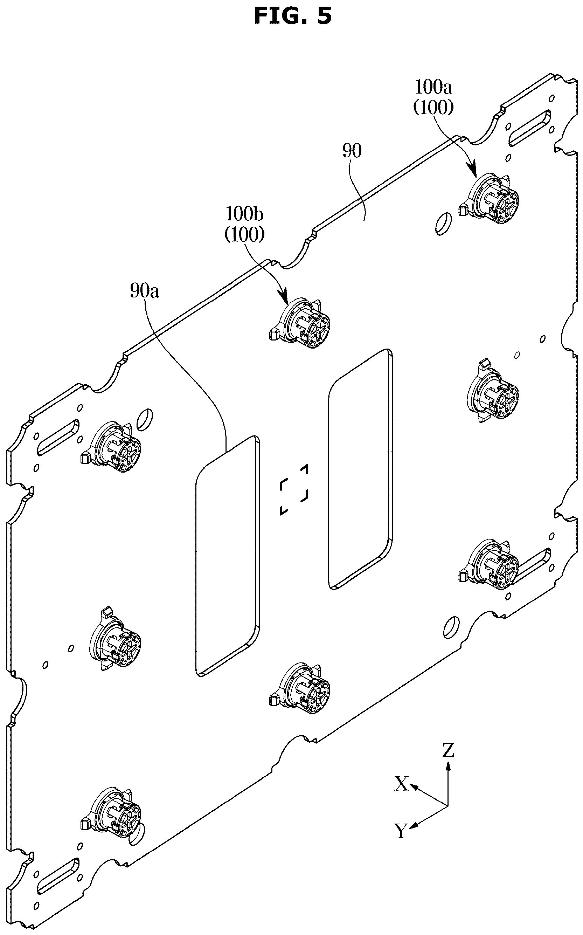

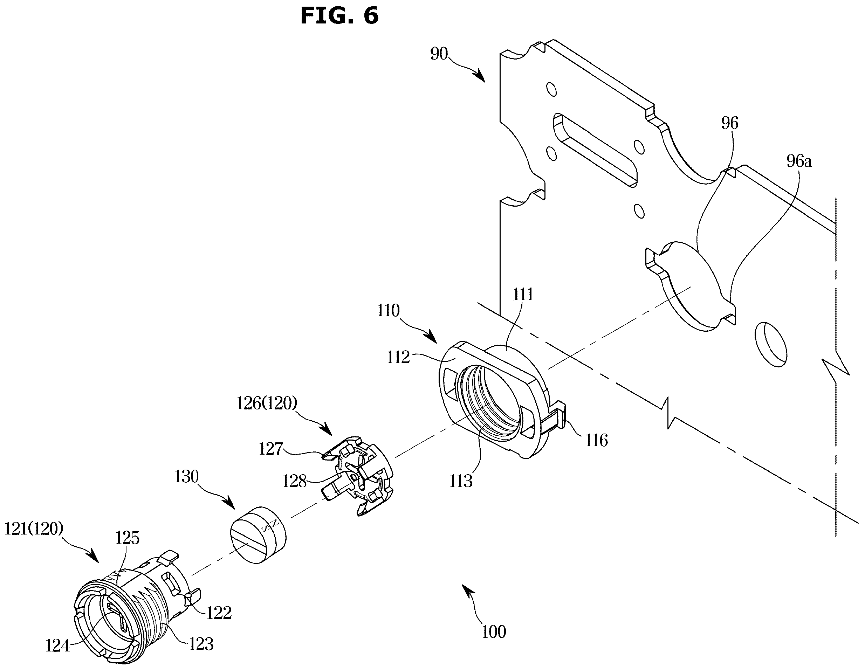

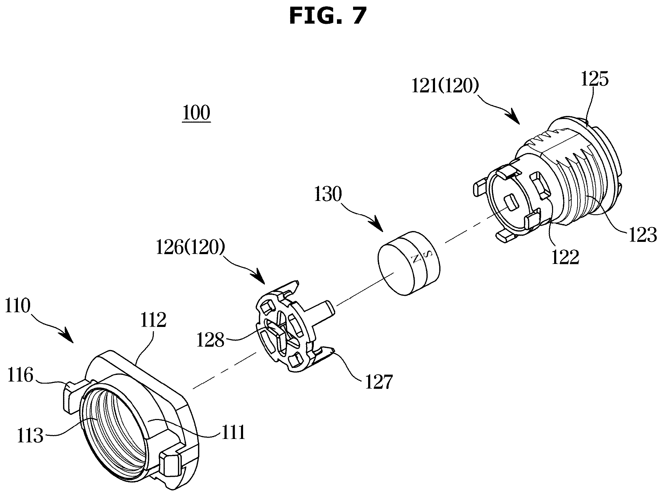

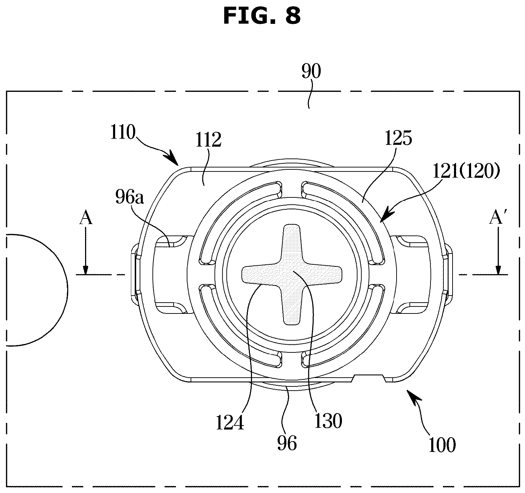

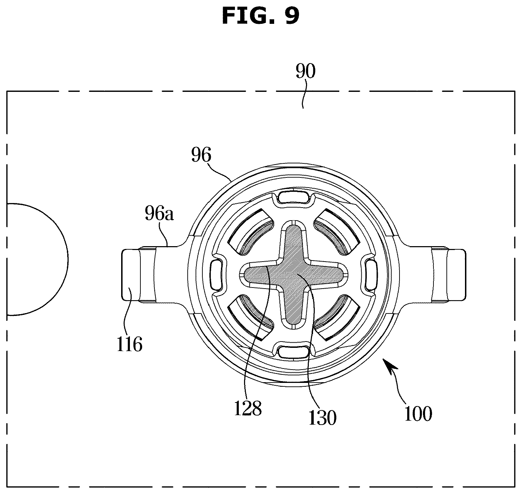

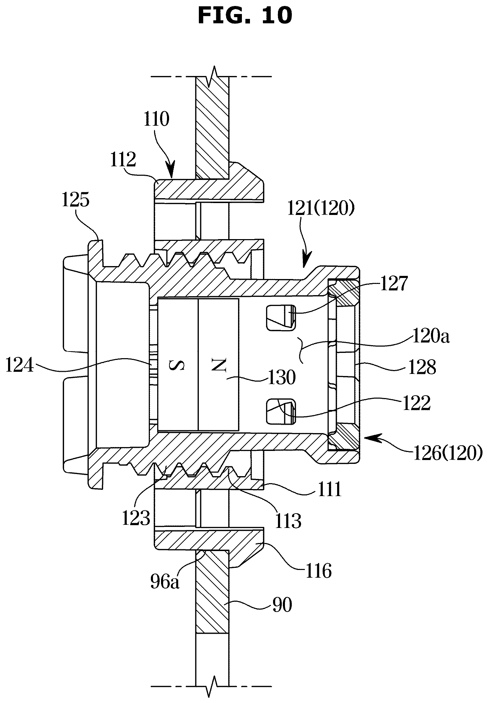

FIG. 5 is a view illustrating a portion of the frame of the display apparatus according to an embodiment of the present disclosure. FIG. 6 is an exploded view illustrating a connection device according to an embodiment of the present disclosure. FIG. 7 is an exploded view illustrating the connection device according to an embodiment of the present disclosure, viewed in an orientation different from that of FIG. 6. FIG. 8 is a front view illustrating a portion of the frame on which the connection device is mounted according to an embodiment of the present disclosure. FIG. 9 is a rear view illustrating a portion of the frame on which the connection device according to an embodiment of the present disclosure is mounted. FIG. 10 is a cross sectional view taken along line A-A' of FIG. 8 showing a portion of the frame on which the connecting device according to an embodiment of the present disclosure.

Referring to FIGS. 5 to 10, the frame 90 of the display apparatus 1 according to an embodiment may include a part mounting portion 96 on which the connection device 100 is to be mounted. As an example, the part mounting portion 96 may have a hole shape. The connection device 100 may be inserted into the part mounting portion 96. The part mounting portion 96 may include a part fixing portion 96a. The part fixing portion 96a may extend outward from the part mounting portion 96.

The connection device 100 may include a fixing part 110 fixed to the frame 90. The fixing part 110 may be provided to be fixed by being hooked to the frame 90. The fixing part 110 may include an insertion portion 111 inserted into the part mounting portion 96 and a support portion 112 having a size larger than the part mounting portion 96. The fixing part 110 may be provided to be coupled to one side of the frame 90. The support portion 112 may be provided to restrict the fixing part 110 from passing through the part mounting portion 96.

The fixing part 110 may be mounted on the part mounting portion 96 of the frame 90. The fixing part 110 may include a frame fixing portion 116. As an example, the frame fixing portion 116 may have a substantially hook shape. The frame fixing portion 116 may be hooked to the part fixing portion 96a while the fixing part 110 is mounted on the part mounting portion 96.

The fixing part 110 may be fixed to the frame 90 as the insertion portion 111 is inserted into the part mounting portion 96, the frame fixing portion 116 is coupled to the part fixing portion 96a, and the support portion 112 is supported on the frame 90.

The fixing part 110 may include an adjustment guide 113 for coupling to an adjustment part 120. The adjustment guide 113 may be provided in a screw thread shape at a portion of the fixing part 110 coupled to the adjustment part 120. The adjustment guide 113 may be formed on an inner peripheral surface of a portion of the fixing part 110 into which the adjustment part 120 is inserted.

The connection device 100 may include the adjustment part 120 for adjusting the gap between the display module 30A and the frame 90. The adjustment part 120 may be movably coupled to the fixing part 110. The adjustment part 120 may be screw-coupled to the fixing part 110. The adjustment part 120 may be provided to move and/or rotate relative to the fixing part 110.

The adjustment part 120 may include an adjustment case 121 inserted into the fixing part 110. The adjustment case 121 may be movably coupled to the fixing part 110. The adjustment case 121 may be rotatably coupled to the fixing part 110.

The adjustment case 121 may include an adjustment portion 123 provided to correspond to the adjustment guide 113 of the fixing part 110. The adjustment portion 123 may be provided in a screw thread shape on a portion of the adjustment case 121 inserted into the fixing part 110. The adjustment portion 123 may be formed on an outer peripheral surface of the adjustment case 121. As the adjustment portion 123 123 of the adjusting case 121 is coupled to the adjustment guide 113 of the fixing part 110, the adjustment part 120 may be movable and rotatable with respect to the fixing part 110. As the adjustment portion 123 guided by the adjustment guide 113 rotates and moves, the adjustment part 120 may rotate and move with respect to the fixing part 110.

The adjustment case 121 may have a substantially cylindrical shape with one side open. The adjustment part 120 may include an adjustment cover 126 provided to cover the one open side of the adjustment case 121. The adjustment case 121 may include a cover mounting portion 122 on which the adjustment cover 126 is mounted. As an example, the cover mounting portion 122 may have a hole shape. The adjustment cover 126 may include a cover fixing portion 127 that enables coupling and fixing to the cover mounting portion 122. The cover fixing portion 127 may be hook-coupled to the cover mounting portion 122.

Referring to FIG. 10, as the adjustment case 121 and the adjustment cover 126 are coupled to each other, a space 120a in which an adjustment magnet 130 is movable may be formed inside the adjustment part 120. The adjustment magnet 130 may be provided to be freely movable in the space 120a formed inside the adjustment part 120.

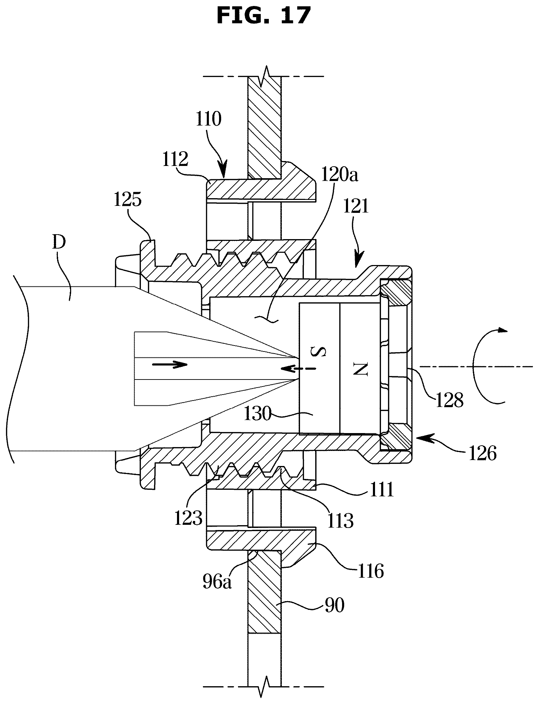

The adjustment part 120 may include a first adjustment portion 124 exposed to allow coupling of an adjustment tool (D, FIG. 17) that is configured to move the adjustment part 120 in a state in which the display module 30A is separated from the frame 90. The first adjustment portion 124 may be provided on the adjustment case 121. The first adjustment portion 124 may be provided to face forward.

The adjustment part 120 may include a second adjustment portion 128 provided to allow coupling of the adjustment tool D on a side opposite to a side on which the first adjustment portion 124 is located. The second adjustment portion 128 may be provided on the adjustment cover 126. The second adjustment portion 128 may be provided to face backward.

The adjustment part 120 may be configured to be operated by the adjustment tool D or configured to be operated by an operator by hand.

The adjustment part 120 may include a limiting portion 125 configured to interfere with the fixing part 110 to limit a range of movement of the adjustment part 120 with respect to the fixing part 110 in a direction in which the display module 30A approaches the frame 90. The limiting portion 125 may be provided to have a size larger than the size of the internal space of the fixing part 110 into which the adjustment case 121 is inserted. Such a structure may prevent the adjustment part 120 from being separated to the rear side of the fixing part 110 by rotating and moving with respect to the fixing part 110.

The connection device 100 may include an adjustment magnet 130 movably coupled to the adjustment part 120. The adjustment magnet 130 may be provided to be movable in the space 120a formed inside the adjustment part 120.

The adjustment magnet 130 may be provided to be movable by the adjustment tool D while the adjustment tool D is coupled to the first adjustment portion 124. The adjustment magnet 130 may be provided to be movable by the adjustment tool D while the adjustment tool D is coupled to the second adjustment portion 128. The adjustment magnet 130 may move toward the second adjustment portion 128 while the adjustment tool D is coupled to the first adjustment portion 124, and may move toward the first adjustment portion 124 while the adjustment tool D is coupled to the second adjustment portion 128.

The adjustment magnet 130 may be provided to be movable between a first position at which the display module 30A is fixable to the frame 90 and a second position at which the display module 30A is releasable from the frame 90.

The adjustment magnet 130 may be provided such that an attractive force is generated between the magnetic material 70 and the adjustment magnet 130 while the display module 30A is mounted on the frame 90. The adjustment magnet 130 may have a force that pulls the magnetic material 70 to maintain the display module 30A mounted on the frame 90. The adjustment magnet 130 may maintain a force to pull the magnetic material 70 while the adjustment part 120 is rotating and/or moving relative to the fixing part 110.

With such a configuration, the display apparatus 1 according to an embodiment of the present disclosure may adjust the gap between the display module 30A and the frame 90. Specifically, the display apparatus 1 may be adjusted for the gap between the display module 30A and the frame 90 to be reduced, or may be adjusted for the gap between the display module 30A and the frame 90 to be increased.

As an example, the display module 30A may move away from the frame 90 as the adjustment part 120 rotates in a first direction. The display module 30A may move away from the frame 90 as the adjustment part 120 rotates in the first direction while the display module 30A is mounted on the frame 90.

For example, the display module 30A may move closer to the frame 90 as the adjustment part 120 rotates in a second direction opposite to the first direction. The display module 30A may move closer to the frame 90 as the adjustment part 120 rotates in the second direction opposite to the first direction while the display module 30A is mounted on the frame 90.

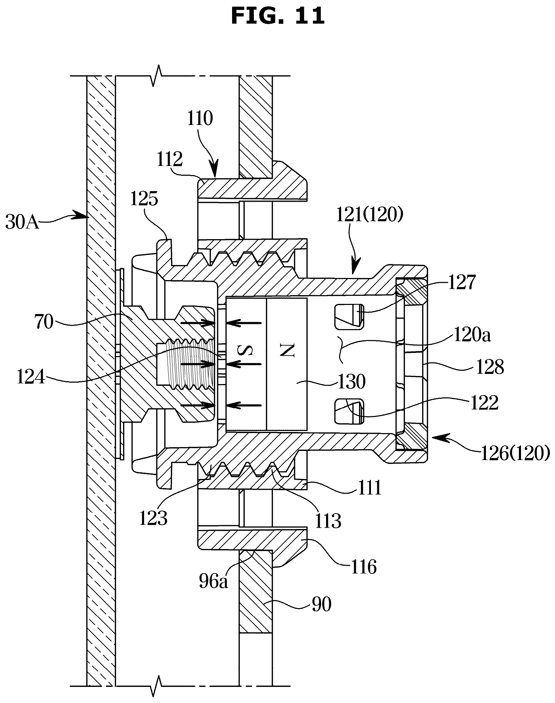

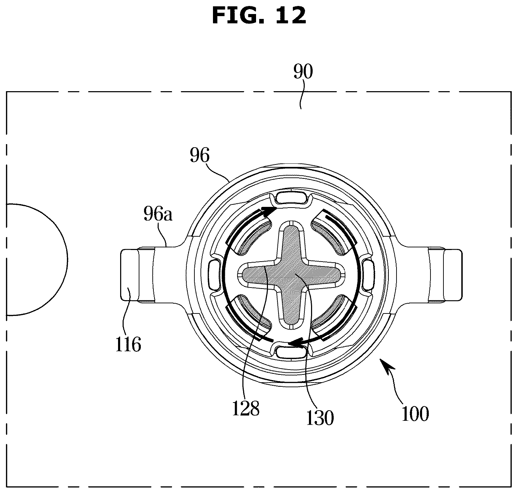

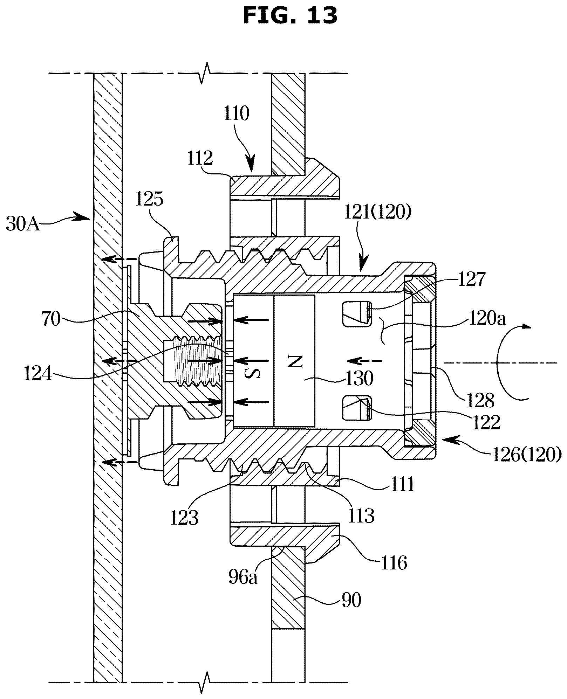

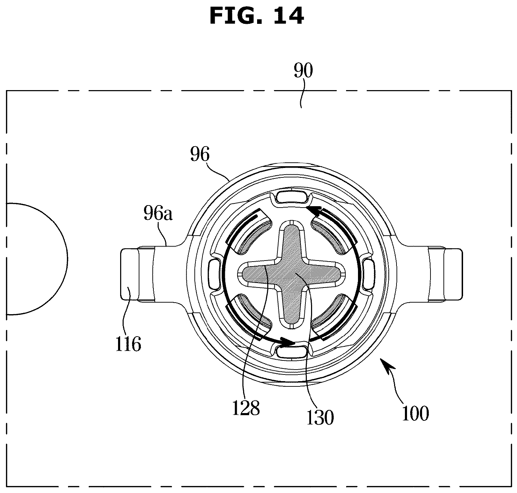

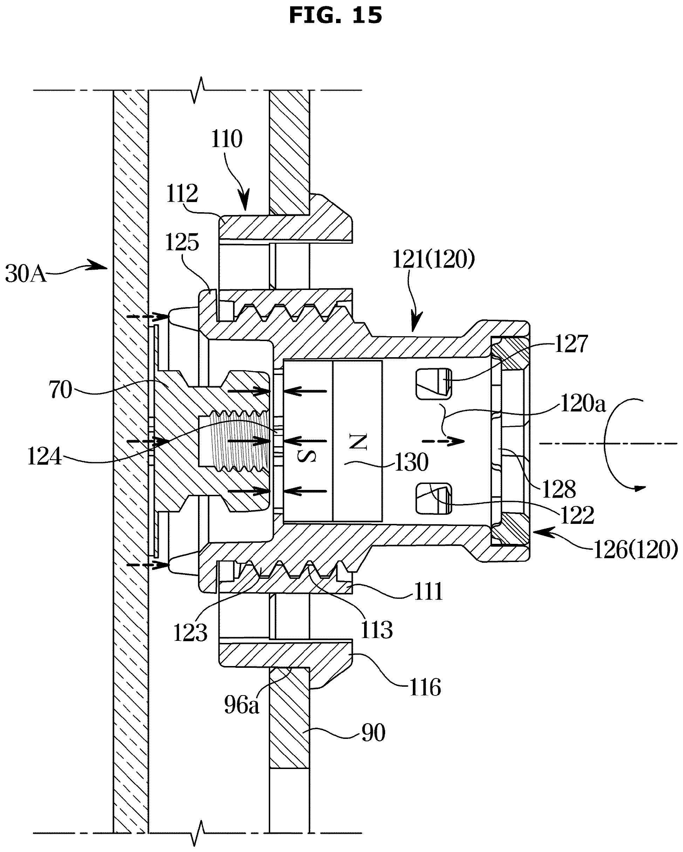

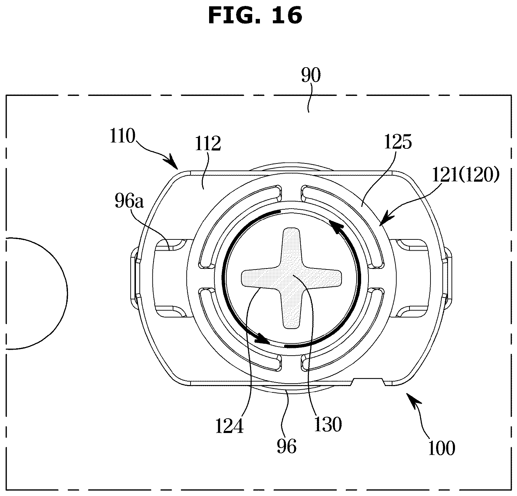

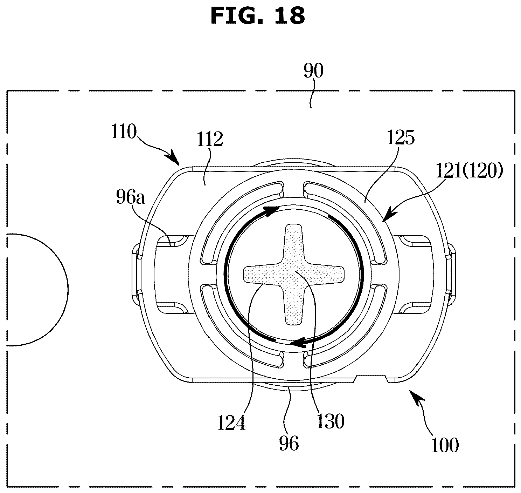

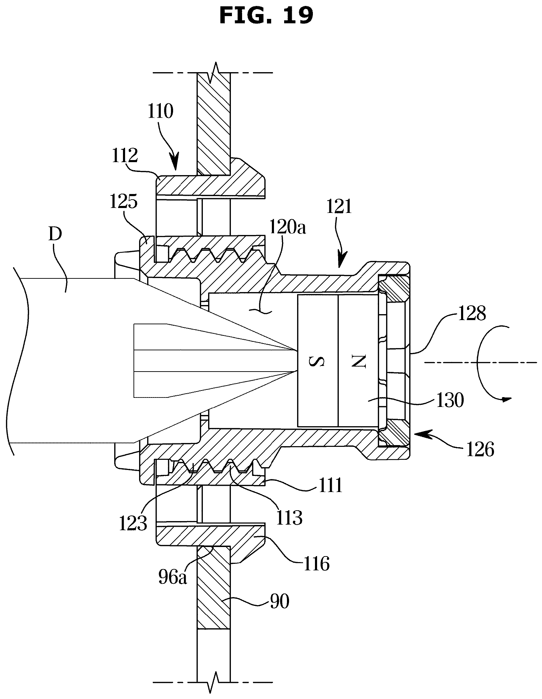

FIG. 11 is a cross-sectional view of the display module mounted on the frame according to an embodiment of the present disclosure. FIG. 12 is a rear view illustrating a rotation of an adjustment part in the first direction according to an embodiment of the present disclosure. FIG. 13 is a view illustrating the display module moved away from the frame as the adjustment part rotates in the first direction according to an embodiment of the present disclosure. FIG. 14 is a rear view illustrating a rotation of the adjustment part in the second direction according to an embodiment of the present disclosure. FIG. 15 is a view illustrating the display module moved closer to a frame as the adjustment part rotates in the second direction according to an embodiment of the present disclosure. FIG. 16 is a front view illustrating a rotation of the adjustment part in the first direction while the display module is separated from the frame according to an embodiment of the present disclosure. FIG. 17 is a view illustrating the adjustment part moved forward as the adjustment part rotates in the first direction while the display module is separated from the frame according to an embodiment of the present disclosure. FIG. 18 is a view illustrating a rotation of the adjustment part in the second direction while the display module is separated from the frame according to an embodiment of the present disclosure. FIG. 19 is a view illustrating the adjustment part moved rearward as the adjustment part rotates in the second direction while the display module is separated from the frame according to an embodiment of the present disclosure.

With reference to FIGS. 11 to 19, a method of adjusting the gap between the display module 30A and the frame 90 of the display apparatus 1 according to an embodiment of the present disclosure will be described.

Referring to FIG. 11, the display module 30A of the display apparatus 1 according to an embodiment may be mounted to the frame 90 by attraction between the magnetic material 70and the adjustment magnet 130 of the connection device 100.

Referring to FIGS. 12 to 15, the display apparatus 1 according to an embodiment may adjust the distance between the display module 30A and the frame 90 by manipulating the adjustment part 120 at the rear of the connection device 100 in a state in which the rear cover 10 is separated from the frame 90.

Referring to FIGS. 12 and 13, the display apparatus 1 according to an embodiment is configured to increase the gap between the display module 30A and the frame 90 as the adjustment part 120 of the connection device 100 rotates in the first direction. The adjustment part 120 may be rotated in the first direction by the adjustment tool (D, see FIGS. 17 and 19). The adjustment part 120 may be directly rotated in the first direction by the operator. The adjustment part 120 may move forward while rotating in the first direction. As the adjustment part 120 moves forward, the display module 30A may move in a direction away from the frame 90. With such a configuration, the gap between the display module 30A and the frame 90 may be increased.

Referring to FIGS. 14 and 15, the display apparatus 1 according to an embodiment may be configured to reduce the gap between the display module 30A and the frame 90 as the adjustment part 120 of the connection device 100 rotates in the second direction. The adjustment part 120 may be rotated in the second direction by the adjustment tool (D, see FIGS. 17 and 19). The adjustment part 120 may be directly rotated in the second direction by the operator. The adjustment part 120 may move backward while rotating in the second direction. As the adjustment part 120 moves backward, the display module 30A may move in a direction closer to the frame 90. With such a configuration, the gap between the display module 30A and the frame 90 may be reduced.

Referring to FIGS. 16 to 19, the display apparatus 1 according to an embodiment may adjust the distance between the display module 30A and the frame 90 by manipulating the adjustment part 120 at the front of the connection device 100 in a state in which the display module 30A is separated from the frame 90.

Referring to FIGS. 16 and 17, the display apparatus 1 according to an embodiment may be configured to increase the gap between the display module 30A and the frame 90 as the adjustment part 120 of the connection device 100 rotates in the first direction. The adjustment part 120 may be rotated in the first direction by the adjustment tool D. The adjustment part 120 may be directly rotated in the first direction by the operator. The adjustment part 120 may move forward while rotating in the first direction. With the adjustment part 120 moved forward, the display module 30A is mounted to the frame 90, and thus the display module 30A and the frame 90 may have an increased gap therebetween.

Referring to FIGS. 18 and 19, the display apparatus 1 according to an embodiment may be configured to reduce the gap between the display module 30A and the frame 90 as the adjustment part 120 of the connection device 100 rotates in the second direction. The adjustment part 120 may be rotated in the second direction by the adjustment tool D. The adjustment part 120 may be directly rotated in the second direction by the operator. The adjustment part 120 may move backward while rotating in the second direction. With the adjustment part 120 moved backward, the display module 30A may be mounted to the frame 90, and thus the display module 30A and the frame 90 may have a reduced gap therebetween.

With such a configuration, the display apparatus 1 according to an embodiment of the present disclosure may individually adjust the gap between the plurality of display modules 30A to30j and the frame 90, and thus the level difference between the plurality of display modules 30A to 30j may be easily adjusted. For example, when some display modules among the plurality of display modules are located backward compared to other display modules, the level differences of the plurality of display modules 30A to 30j may be adjusted by moving the adjustment part 120 forward with respect to the fixing part 110. For example, when some display modules among the plurality of display modules 30A to 30j protrude forward compared to other display modules, the level differences of the plurality of display modules 30A to 30j may be adjusted by moving the adjustment part 120 backward with respect to the fixing part 110.

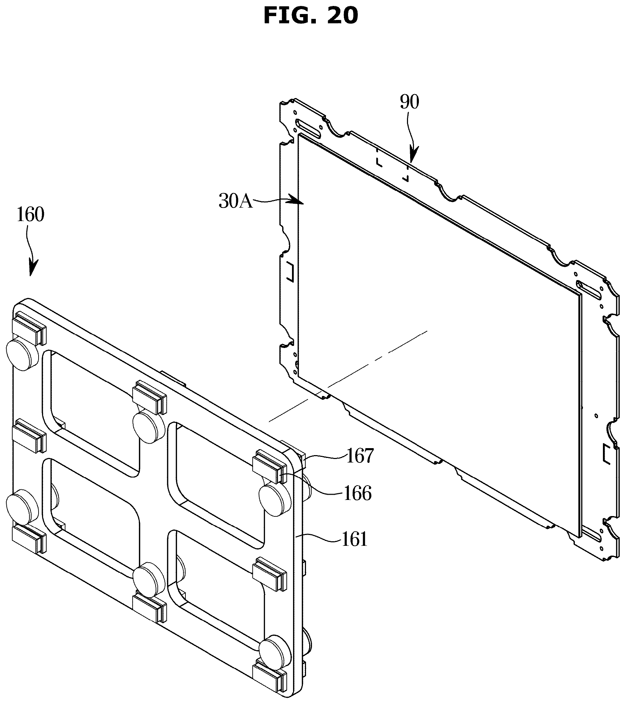

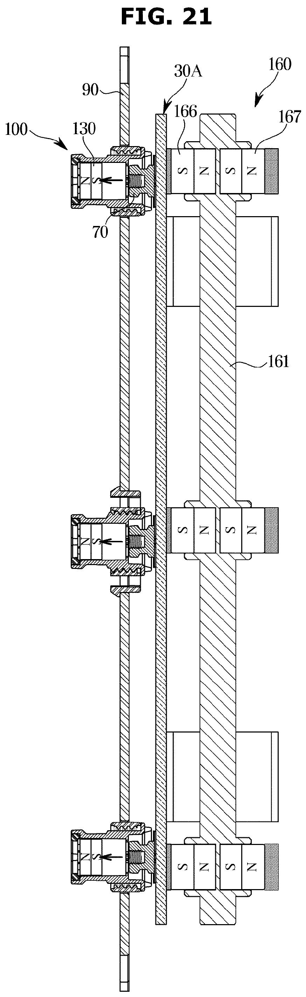

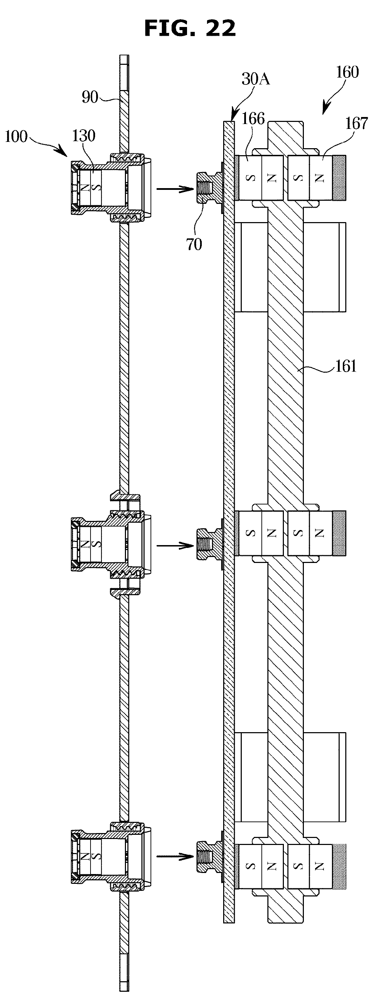

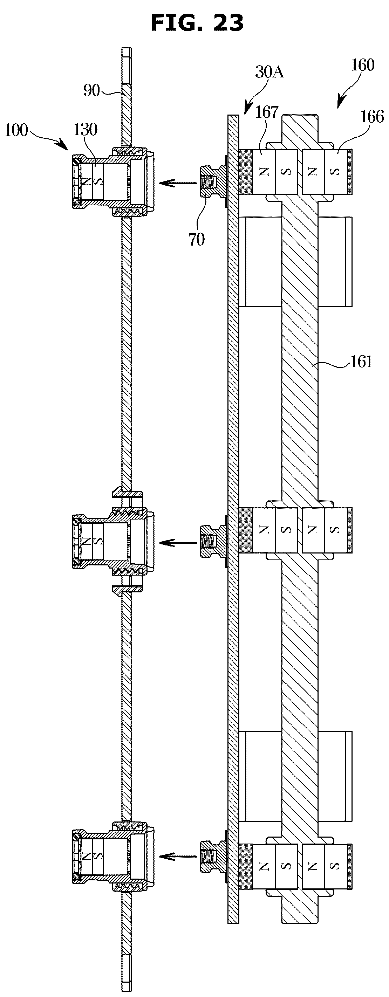

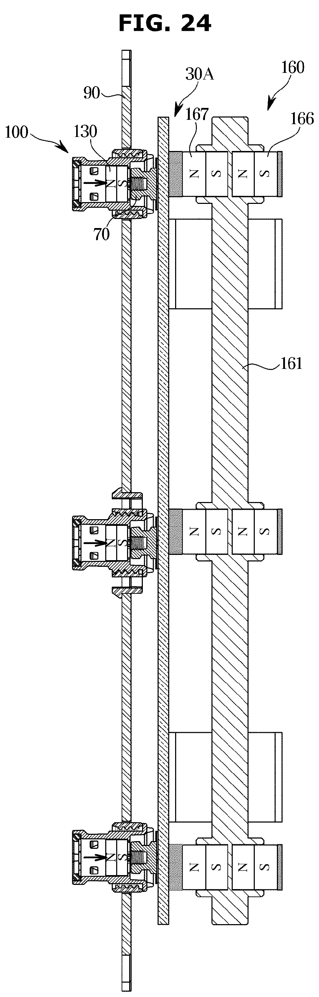

FIG. 20 is a view illustrating a portion of the display apparatus according to an embodiment of the present disclosure and a jig device for separating the display module from the frame. FIG. 21 is a view illustrating a state in which the jig device is attached to the display apparatus to separate the display module of the display apparatus from the frame according to an embodiment of the present disclosure. FIG. 22 is a view illustrating a state in which the display module of the display apparatus according to an embodiment of the present disclosure is separated from the frame by the jig device. FIG. 23 is a view illustrating a state in which the jig apparatus is attached to the display apparatus to mount the display module of the display apparatus to the frame according to an embodiment of the present disclosure. FIG. 24 is a view illustrating a state in which the display module of the display apparatus according to an embodiment of the present disclosure is mounted on the frame using the jig device.

Referring to FIG. 20, the display module 30A of the display apparatus 1 according to an embodiment may be separated from the frame 90 through a jig device 160. The jig device 160 may include a jig body 161 and jig magnets 166 and 167 provided to interact with the magnetic material 70 of the display module 30A. The jig magnets 166 and 167 may include a separating magnet 166 located on a first side of the jig body 161 and a mounting magnet 167 located on a second side of the jig body 161.

Referring to FIGS. 21 to 24, a portion of the separating magnet 166 attached to the display module 30A may have a magnetic pole opposite to that of a portion of the mounting magnet 167 attached to the display module 30A.

Referring to FIG. 21, the adjustment magnet 130 may, in a state in which the display module 30A is mounted on the frame 90, move in a direction away from the magnetic material 70 as the jig device including the jig magnets 166 and 167 having stronger magnetism than the adjustment magnet 130 is attached to the display module 30A,

Specifically, in order to separate the display module 30A from the frame 90, the jig device 160 may be positioned such that the separating magnet 166 is attached to the display module 30A. As an example, the separating magnet 166 may be provided with an S pole facing the display module 30A, and the adjustment magnet 130 of the connection device 100 may be provided with an S pole facing the display module 30A. The magnetic force of the separating magnet 166 may be greater than the magnetic force of the adjustment magnet 130 of the connection device 100. As the separating magnet 166 approaches the magnetic material 70 provided in the display module 30A, the adjustment magnet 130, which has a relatively weak magnetic force, is moved in a direction away from the magnetic material 70 due to the repulsive force generated between the separating magnet 166 and the adjustment magnet 130.

Referring to FIG. 22, the display module 30A may be separated from the frame 90 while being attached to the jig device 160 by the attractive force between the separating magnet 166 and the magnetic material.

Referring to FIG. 23, the adjustment magnet 130 may, in a state in which the display module 30A is separated from the frame 90, move in a direction closer to the magnetic material 70 as the display module 30A, which is attached to the jig device including the jig magnets 166 and 167 having stronger magnetism than the adjustment magnet 130, is mounted to the frame 90.

Specifically, in order to mount the display module 30A on the frame 90, the jig device 160 may be positioned such that the mounting magnet 167 is attached to the display module 30A. As an example, the mounting magnet 167 may be provided with an N pole facing the display module 30A, and the adjustment magnet 130 of the connection device 100 may be provided with an S pole facing the display module 30A. The magnetic force of the mounting magnet 167 may be greater than the magnetic force of the adjustment magnet 130 of the connection device 100. As the mounting magnet 167 together with the display module 30A approaches the connection device 100 mounted on the frame 90, magnetic material the adjustment magnet 130 is moved in a direction closer to the magnetic material 70 due to the attractive force generated between the mounting magnet 167 and the adjustment magnet 130.

Referring to FIG. 24, the display module 30A may be mounted to the frame 90 by the attractive force of the adjustment magnet 130 and the magnetic material 70, and the jig device 160 may be separated from the display module 30A by external force.

With such a configuration of the display apparatus 1 according to an embodiment of the present disclosure, the display module 30A may be easily separated from the frame 90 and the adjustment part 120 may be adjusted at the front of the connection device 100.

A display apparatus 1 according to an embodiment includes: a display module 30A provided with a magnetic material 70; a frame 90 configured to support the display module; and a connection device 100. The connection device includes: a fixing part 110 fixed to the frame; an adjustment part 120 movably coupled to the fixed part so as to be movable with respect to the fixing part; and an adjustment magnet 130 movably coupled to the adjustment part so as to movable with respect to the adjustment part, and configured to generate an attractive force between the magnetic body and the adjustment magnet to mount the display module to the frame so that the display module is supported by the frame with a gap between the display module and the frame. The gap is adjustable by movement of the adjustment part with respect to the fixing part

The adjustment part may include a first adjustment portion 124 that is exposed to allow coupling of an adjustment tool D configured to move the adjustment part while the display module is separated from the frame.

The adjustment magnet may be configured to be movable by the adjustment tool while the adjustment tool is coupled to the first adjustment portion.

The adjustment part may include a second adjustment portion 128 configured to allow coupling of the adjustment tool at a side of the adjustment part opposite to a side of the adjustment part at which the adjustment tool is couplable to the first adjustment portion.

The adjustment magnet may be configured to be movable by the adjustment tool while the adjustment tool is coupled to the second adjustment portion.

The adjustment part may be screw-coupled to the fixing part to enable movement and rotation of the adjustment part relative to the fixing part.

The display module may be configured to: through the adjustment part being rotated in a first direction, move in a direction away from the frame while the display module is mounted to the frame; and through the adjustment part being rotated in a second direction opposite to the first direction, move in a direction closer to the frame while the display module is mounted to the frame.

The adjustment part may include an adjustment case 121 having an open side; and an adjustment cover 126 covering the open side of the adjustment case. The adjustment case and the adjustment cover together form a space in which the adjustment magnet is movable with respect to the adjustment part.

The fixing part may be configured to be fixed to the frame by being hooked to the frame.

The adjustment magnet may be configured to, while the display module is mounted on the frame, move in a direction away from the magnetic body as a jig device 160 including jig magnets 166 and 167 stronger magnetism than the adjustment magnet is attached to the display module.

The adjustment magnet is configured to, while the display module is separated from the frame, move in a direction closer to the magnetic body as the display module, which is attached to a jig device including jig magnets having stronger magnetism than the adjustment magnet, is mounted to the frame.

The magnetic material may include a first magnetic material 71 located on an edge of the display module; and a second magnetic material 72 located on the edge of the display module and spaced apart from the first magnetic material 71.

The connection device may include a first connection device 100a positioned to correspond to the first magnetic material; and a second connection device 100b positioned to correspond to the second magnetic material 70 and spaced apart from the first connection device.

The adjustment magnet may be movable between a first position at which the display module may be mountable to the frame and a second position at which the display module may be unfixable from the frame.

The adjustment part may include a limiting portion 125 configured to interfere with the fixing part to limit a range of movement of the adjustment part with respect to the fixing part in a direction in which the display module approaches the frame.

The adjustment part may be movable with respect to the fixing part prior to the display module being mounted to the frame, to adjust the gap that will be between the display module and the frame when the display module is mounted to the frame.

The adjustment part may be movable with respect to the fixing part after the display module is mounted to the frame, to adjust the gap.

The adjustment part may be movable with respect to the fixing part prior to the display module being mounted to the frame to adjust the gap that will be between the display module and the frame when the display module is mounted to the frame, and be moveable with respect to the fixing part after the display module is mounted to the frame to adjust the gap.

A display apparatus 1 according to an embodiment includes: a display module 30A on which a magnetic material 70 is provided; a frame 90 configured to support the display module; and a connection device 100 configured to mount the display module on the frame. The connection device includes a fixing part 110 fixed to the frame, an adjustment part 120 movably coupled to the fixing part, and an adjustment magnet 130 movably coupled to the adjustment part, the adjustment magnet being movable between a first position at which the display module is fixable to the frame and a second position at which the display module is released from the frame. The display module is adjustable in distance to the frame based on the adjustment part moving relative to the fixed part in a state in which the display module is mounted on the frame by attraction between the adjustment magnet and the magnetic material.

The adjustment part may include: a first adjustment portion 124 that is exposed to allow coupling of an adjustment tool D configured to move the adjustment part while the display module is separated from the frame; and a second adjustment portion 128 provided to allow coupling of the adjustment tool at a side opposite to a side at which the first adjustment portion is located.

The adjustment magnet may be provided to be movable by the adjustment tool while the adjustment tool is coupled to the first adjustment portion or the second adjustment portion.

The display module may be configured to: through the adjustment part being rotated in a first direction, move in a direction away from the frame; and through the adjustment part being rotated in a second direction opposite to the first direction, move in a direction closer to the frame.

The adjustment magnet may move in a direction -away from or closer to the magnetic material as a jig device including jig magnets having stronger magnetism than the adjustment magnet is attached to the display module.

According to an aspect of the present disclosure, the display apparatus is implemented such that the level differences of a plurality of display modules can be adjusted while the plurality of display modules are mounted on the frame, thereby improving the manufacturing process.

According to an aspect of the present disclosure, the display apparatus is implemented such that not only the level differences of a plurality of display modules in a state mounted on the frame can be adjusted but also the gap of at least one display module, among the plurality of display modules, that is separated from the frame can be adjusted, thereby facilitating maintenance and/or repair.

According to an aspect of the present disclosure, the display apparatus is implemented such that the level difference between the plurality of display modules can be adjusted without separating the plurality of display modules from the frame, thereby reducing the risk of damage to the display module during maintenance and/or repair.

The effects of the present disclosure are not limited to the effects described above, and other effects that are not described will be clearly understood by those skilled in the art from the following description.

Specific embodiments illustrated in the drawings have been described above. However, the disclosure is not limited to the embodiments described above, and those of ordinary skill in the art to which the disclosure pertains may make various changes thereto without departing from the gist of the technical concept of the disclosure defined in the claims below.

## Claims

1. A display apparatus comprising:
a display module provided with a magnetic material;
a frame configured to support the display module; and
a connection device including:
a fixing part fixed to the frame,
an adjustment part movably coupled to the fixing part so as to be movable with respect to the fixing part, and
an adjustment magnet movably coupled to the adjustment part so as to movable with respect to the adjustment part, and configured to generate an attractive force between the magnetic material and the adjustment magnet to mount the display module to the frame so that the display module is supported by the frame with a gap between the display module and the frame,
wherein the gap is adjustable by movement of the adjustment part with respect to the fixing part.

2. The display apparatus of claim 1, wherein the adjustment part includes a first adjustment portion that is exposed to allow coupling of an adjustment tool configured to move the adjustment part while the display module is separated from the frame.

3. The display apparatus of claim 2, wherein the adjustment magnet is configured to be movable by the adjustment tool while the adjustment tool is coupled to the first adjustment portion.

4. The display apparatus of claim 2, wherein the adjustment part includes a second adjustment portion configured to allow coupling of the adjustment tool at a side of the adjustment part opposite to a side of the adjustment part at which the adjustment tool is couplable to the first adjustment portion.

5. The display apparatus of claim 4, wherein the adjustment magnet is configured to be movable by the adjustment tool while the adjustment tool is coupled to the second adjustment portion.

6. The display apparatus of claim 1, wherein the adjustment part is screw-coupled to the fixing part to enable movement and rotation of the adjustment part relative to the fixing part.

7. The display apparatus of claim 1, wherein the display module is configured to:
through the adjustment part being rotated in a first direction, move in a direction away from the frame while the display module is mounted to the frame, and
through the adjustment part being rotated in a second direction opposite to the first direction, move in a direction closer to the frame while the display module is mounted to the frame.

8. The display apparatus of claim 1, wherein the adjustment part includes:
an adjustment case having an open side, and
an adjustment cover covering the open side of the adjustment case,
wherein the adjustment case and the adjustment cover together form a space in which the adjustment magnet is movable with respect to the adjustment part.

9. The display apparatus of claim 1, wherein the fixing part is configured to be fixed to the frame by being hooked to the frame.

10. The display apparatus of claim 1, wherein the adjustment magnet is configured to, while the display module is mounted on the frame, move in a direction away from the magnetic material as a jig device including a jig magnet having stronger magnetism than the adjustment magnet is attached to the display module.

11. The display apparatus of claim 1, wherein the adjustment magnet is configured to, while the display module is separated from the frame, move in a direction closer to the magnetic material as the display module, which is attached to a jig device including a jig magnet having stronger magnetism than the adjustment magnet, is mounted to the frame.

12. The display apparatus of claim 1, wherein the magnetic material includes
a first magnetic material located on an edge of the display module, and
a second magnetic material located on the edge of the display module and spaced apart from the first magnetic material.

13. The display apparatus of claim 12, wherein the connection device includes:
a first connection device positioned to correspond to the first magnetic material, and
a second connection device positioned to correspond to the second magnetic material and spaced apart from the first connection device.

14. The display apparatus of claim 1, wherein the adjustment magnet is movable between a first position at which the display module is mountable to the frame and a second position at which the display module is released from the frame.

15. The display apparatus of claim 1, wherein the adjustment part includes a limiting portion configured to interfere with the fixing part to limit a range of movement of the adjustment part with respect to the fixing part in a direction in which the display module approaches the frame.
